# EUROPEAN PATENT APPLICATION

(11) **EP 0 836 230 A2**
(43) Date of publication of application: **15.04.1998**
(21) Application number: 97307833.0
(22) Date of filing: 03.10.1997
(51) Int. Cl.: H01L 27/02

(54) **Power transistor**

(30) Priority: 14.10.1996 JP 270991/96
(71) Applicant: SHARP KABUSHIKI KAISHA, Osaka-shi, Osaka-fu 545 (JP)
(72) Inventor: Ueuchi, Gen, Yamatotakada-shi, Nara 635 (JP)
(74) Representative: Suckling, Andrew Michael

(57) **Abstract**

A planar-type transistor is formed by selectively diffusing a base layer on a surface of a silicon substrate that will act as a collector layer, and then selectively diffusing an emitter layer on the base layer. In addition, the collector layer on the front surface of the planar-type transistor chip is provided with a current detecting electrode, while the back surface of the silicon substrate is provided with a collector electrode. As the transistor is turned on and current flows through the collector, voltage is induced between the collector electrode and the current detecting electrode according to the collector current because of the resistance of the silicon substrate. Therefore, the transistor can quickly and precisely detect the collector current and transmits the detected current as a current detecting signal from the current detecting electrode to a control IC. A power transistor which surely prevents destruction by a surge and allows for reduction of the transistor chip in size can be offered in this manner.

## Description

### FIELD OF THE INVENTION

The present invention relates to a power transistor causing a small loss at medium and large current and suitably used for switching regulators, series regulators with a two-chip structure of a control IC and a power transistor, and other power supply circuits which are likely to induce a surge.

### BACKGROUND OF THE INVENTION

In order to prevent an increase in current capacity and destruction of an element due to current concentration, conventional power transistors are structured to include, as examples, surface electrodes shaped in a mesh form, or a base ballast resistor and an emitter ballast resistor.

However, even with such structures, the element may still be destructed when a current exceeding the rated current value passes through the element. Besides, transistors for use at medium and large current are in many cases used in such a manner that a surge current several to several tens of times normal operating current flows therethrough for an instant.

It is increasingly popular to provide a power transistor incorporating a control IC, such as an element for a regulator, with a protective function so that the element is not destructed no matter what happens. In this case, it is necessary to detect the over current and the junction temperature of a transistor chip quickly and precisely before the element is destructed, and to feedback the detected results to the control IC.

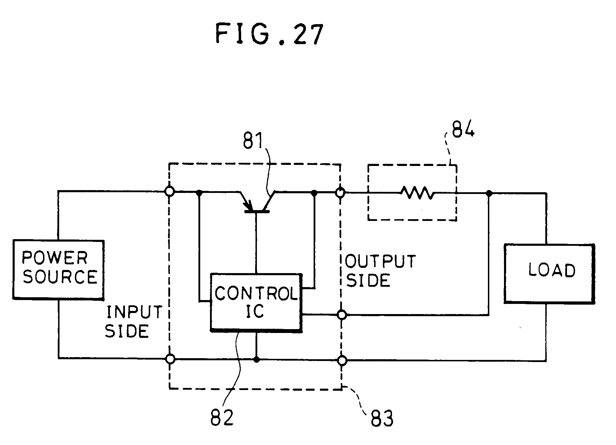

Figs. 27 through 30 show a structure of a small-loss series regulator, constituted by a PNP power transistor 81 and a control IC 82. In the structure, the control IC 82 prevents a surge current from destructing the power transistor 81, by limiting the base current of the power transistor 81 when over current or overheating is detected.

Fig. 27 shows the control IC 82 receiving as a signal a voltage drop caused by an over current detecting resistor 84 provided to the collector (or emitter) of the power transistor 81 (hereinafter, this will be referred to as Conventional Technique 1). Note that "83" in the figure represents a regulator element.

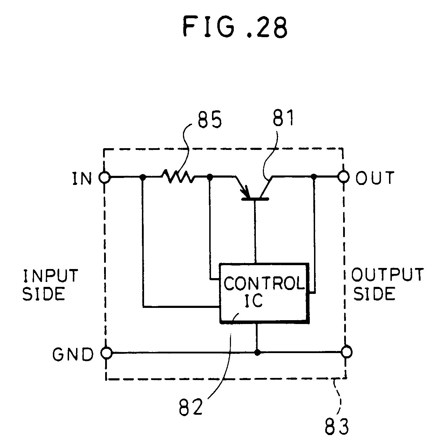

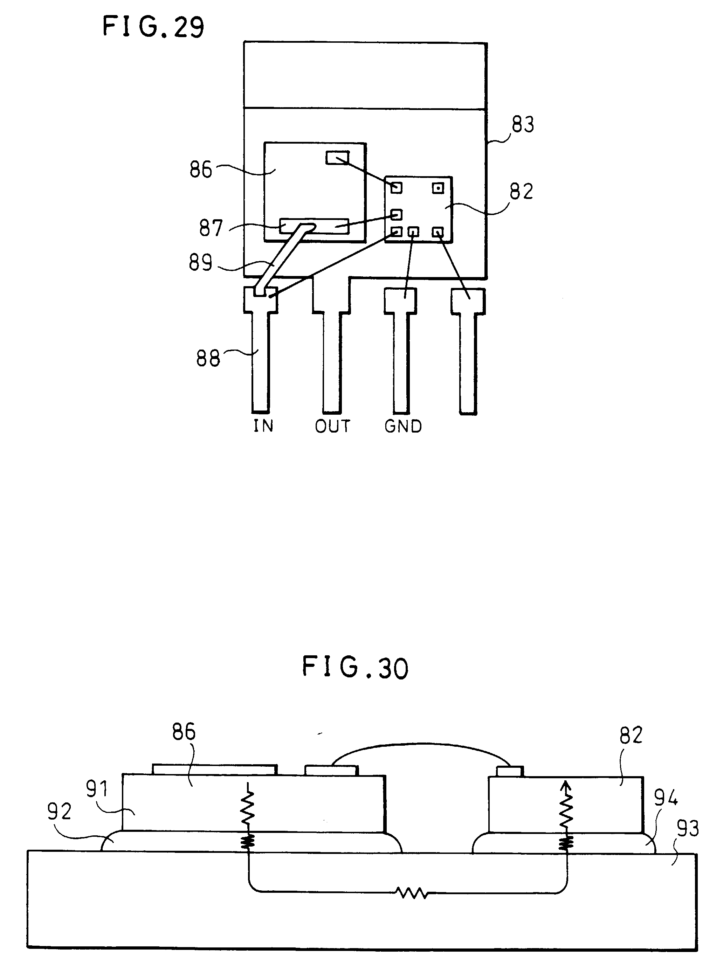

Figs. 28 and 29 show the control IC 82 receiving as a signal a voltage drop caused by resistance of a wiring line 89 (shown as a resistor 85 in Fig. 28), that is used as an over current detecting resistor in the regulator element 83, the wiring line 89 connecting a frame terminal 88 to an emitter electrode 87 that is a surface electrode of a transistor chip 86 (hereinafter, this will be referred to as Conventional Technique 2).

Another method against the destruction of the power transistor chip is to detect a rise in junction temperature of the transistor chip quickly and limit the base current with the control IC (hereinafter, this will be referred to as Conventional Technique 3).

Conventional Technique 1, nevertheless, has inherent problems: The over current detecting resistor 84 needs to be of a large size to withstand a larger current than the current flowing through the power transistor 81, and to be disposed outside separately from the regulator element 83 for heat radiation. In addition, if a resistor is connected in series to a small-loss regulator using the PNP transistor of a low saturation voltage, the element is unpreferably placed in a reverse position in terms of its properties.

Conventional Technique 2 also has inherent problems: The voltage to be detected is low, and the value of the resistance is greatly varied by, for example, the length of the wire, the distortion of the bonding section due to wire bonding, since the wiring line 89 is typically composed of aluminum or metal wire, and has a large diameter to minimize the voltage difference between the input and the output for the regulator element 83, that is, to reduce the resistance of the regulator element 83 as much as possible. In addition, if a regulator that turns on the transistor in an active region is used, it is impossible to detect current with the collector-emitter voltage.

With Conventional Technique 3, as shown in Figs. 29 and 30, as for a two-chip structure of the transistor chip 86 and the control IC 82, heat generated on the surface of the transistor is conducted via a silicon substrate 91, solder 92, a copper frame 93, and insulating adhesive 94 to the control IC 82. However, heat resistance of those components retards the heat conduction to the control IC 82, causing the transistor chip 86 to be destructed before the base current is limited. In additional, since a heat radiation plate is provided, when the transistor chip 86 has a small area, and the heat resistance between the transistor chip 86 and the copper frame 93 is large, the conditions becomes even worse.

### SUMMARY OF THE INVENTION

In view of the problems, an object of the present invention is to offer a power transistor which can quickly and precisely detect current or junction temperature, and which allows for reduction of the transistor chip in size.

In order to accomplish the above object, a power transistor in accordance with the present invention is characterized by the inclusion of:
a transistor chip including
   a silicon substrate that will act as a collector layer,
   a base layer formed on the silicon substrate by selective diffusion, and
   an emitter layer formed on the base layer by selective diffusion; and

   a current detecting electrode, provided to the collector layer on a surface of the transistor chip on the side of the base layer, for deriving a voltage drop caused by the resistance of the silicon substrate as a current detecting signal.

With the configuration, the resistance of the silicon substrate can be used as a resistor for detecting current by providing the current detecting electrode to the collector layer on the surface of the transistor chip. The current detecting electrode, since provided on the surface of the transistor chip and connected to the collector layer on the surface of the transistor chip, can be fabricated by the same step as the emitter electrode and the base electrode. It thus becomes possible to realize a power transistor that can be fabricated by the same process as a normal power transistor, and that can quickly and precisely detect the collector current. Moreover, since the resistance of the silicon substrate is a structurally integral factor for a power transistor with the collector current passing through the silicon substrate, the resistance value of the entire power transistor can be maintained at the same value as in a case of not detecting the collector current. In addition, since it becomes unnecessary to provide an external resistor for detecting over current, it becomes possible to reduce in size, and simplify, the entire circuit using a power transistor.

Moreover, with the power transistor configured as above, since the collector current can be quickly and precisely detected, it is possible to shorten the time lag between the start of the flow of over current through the power transistor and the control of the power transistor by a control circuit hereof. This surely prevents a surge from destructing the power transistor. It is therefore possible to specify the surge withstanding capability of the power transistor to be at the same level as that in normal use conditions. As a result, the chip size of the power transistor can be greatly reduced, in comparison to conventional power transistors.

Moreover, if the power transistor includes a field plate electrode for improving the withstand voltage with field plate effects, the current detecting electrode is better formed as a part of the field plate electrode. This eliminates the need to form a new current detecting electrode, further simplifying the configuration of the power transistor.

Meanwhile, a power transistor in accordance with another embodiment of the present invention, in order to accomplish the above object, is characterized by the inclusion of:
a transistor chip including
   a silicon substrate that will act as a collector layer,
   a base layer formed on the silicon substrate by selective diffusion, and
   an emitter layer formed on the base layer by selective diffusion;

a detecting section, provided to the collector layer on a surface of the transistor chip on the side of the base layer, for detecting temperature;
a first electrode provided to the transistor chip on the side of the base layer and electrically connected to the detecting section; and
a second electrode provided to the transistor chip on the side of the base layer and electrically connected to the detecting section,
the first and second electrodes being connected to the detecting section at different places. Note that the detecting section can be realized with, for example, a diode or a resistor of a small area formed by diffusion. In this case, the junction temperature of the power transistor can be detected by measuring the forward voltage of the diode or resistance value of the resistor that vary in proportion to the temperature.

With the configuration, since the detecting section and the first and second electrodes are provided on the transistor chip, the detecting section has a temperature that is equal to the junction temperature of the power transistor. Therefore, sudden heat generation by the power transistor, which has been conventionally difficult to be detected, can be quickly and precisely detected. Besides, since it is possible to shorten the time lag between the start of the heat generation by the power transistor and the control of the power transistor by a control circuit thereof, a surge can be surely prevented from destructing the power transistor. It is therefore possible to specify the surge withstanding capability of the power transistor to be at the same level as that in normal use conditions. As a result, the chip size of the power transistor can be greatly reduced, in comparison to conventional power transistors.

Furthermore, the detecting section and both electrodes can be fabricated by the same step as are structurally integral factors for the power transistor such as the base and emitter diffusion layers or the base and emitter electrodes. Therefore, it is possible to manufacture a temperature detectable power transistor by the same process as are power transistors without detecting sections.

In addition, since the first and second electrodes are formed on the surface of the transistor chip, the current passing between the electrodes for detecting temperature mainly travels along the surface of the transistor chip. Therefore, it is possible to maintain the resistance value between the detecting section and the electrodes at a low level, and hence restrain loss by that current, compared to a case where the current for detecting temperature flows through the transistor substrate. Besides, it is possible to enhance precision in detection, since the current for detecting temperature is free from affection of irregular resistance and temperature characteristics of the silicon substrate.

The detection section is more preferably located in the central part of the transistor chip. In a power transistor, there is a current concentration and the highest likelihood of heat generation in the central part of the transistor chip. Therefore, locating the detection section in the central part of the transistor chip makes it possible to more quickly and precisely detect overheating of the power transistor.

For a fuller understanding of the nature and advantages of the invention, reference should be made to the ensuing detailed description taken in conjunction with the accompanying drawings.

### BRIEF DESCRIPTION OF THE DRAWINGS

Fig. 1 is a cross-sectional view showing a structure of a power transistor of a first embodiment in accordance with the present invention.
Fig. 2 is an equivalent circuit diagram showing a power transistor having the structure shown in Fig. 1.
Fig. 3 is a block diagram showing a small-loss stabilizing power supply incorporating the power transistor with the above structure.
Fig. 4 is a cross-sectional view showing a structure of a power transistor which is a modified example of the above power transistor.
Fig. 5 is a plan view showing the power transistor.
Fig. 6 is a cross-sectional view showing a structure of a power transistor including a junction temperature detecting diode, of another embodiment in accordance with the present invention.
Fig. 7 is an equivalent circuit diagram showing a power transistor having the structure shown in Fig. 6.
Fig. 8 is a graph showing changes in forward voltage against junction temperature when 1 mA in forward current is passing through the junction temperature detecting diode of a power transistor having the structure shown in Fig. 6.
Fig. 9 is a cross-sectional view showing an embodiment with the junction temperature detecting diode disposed at a different position.
Fig. 10 is an equivalent circuit diagram showing a power transistor having the structure shown in Fig. 9.
Fig. 11 is a cross-sectional view showing an embodiment with the junction temperature detecting diode disposed at an even different position.
Fig. 12 is an equivalent circuit diagram showing a power transistor having the structure shown in Fig. 11.
Fig. 13 is a plan view showing a structure of the power transistor shown in Fig. 6 or 9.
Fig. 14 is a plan view showing a structure of a power transistor shown in Fig. 11.
Fig. 15 is a cross-sectional view showing a structure of a power transistor of even another embodiment in accordance with the present invention.
Fig. 16 is an equivalent circuit diagram showing a power transistor having the structure shown in Fig. 15.
Fig. 17 is a graph showing changes in resistance against junction temperature when a junction temperature detecting resistor of a power transistor having the structure shown in Fig. 15 is 10 µm wide and 400 µm long.
Fig. 18 is a cross-sectional view showing an embodiment with the junction temperature detecting resistor disposed at a different position.
Fig. 19 is an equivalent circuit diagram showing a power transistor having the structure shown in Fig. 18.
Fig. 20 is a cross-sectional view showing an embodiment with the junction temperature detecting resistor disposed at a different position.
Fig. 21 is an equivalent circuit diagram showing a power transistor having the structure shown in Fig. 20.
Fig. 22, an embodiment with the junction temperature detecting resistor disposed at a different position, is a cross-sectional view showing a pinch resistance structure giving the largest resistance value.
Fig. 23 is an equivalent circuit diagram showing a power transistor having the structure shown in Fig. 22.
Fig. 24, an embodiment with the junction temperature detecting resistor disposed at a different position, is a cross-sectional view showing a structure using an emitter diffusion resistor of a high density and a minimum resistance.
Fig. 25 is an equivalent circuit diagram showing a power transistor having the structure shown in Fig. 24.
Fig. 26 is a plan view showing a structure of the power transistor shown in Fig. 15.
Fig. 27, a conventional example, is a circuit diagram showing a configuration of a small-loss series regulator constituted by a PNP transistor and a control IC, in which an over detecting resistor is provided to the collector of the power transistor.
Fig. 28 is a circuit diagram showing a configuration of a small-loss series regulator constituted by a PNP transistor and a control IC, in which the resistor of the wiring connecting the emitter electrode to the frame terminal is used as an over current detecting resistor.
Fig. 29 is a plan view showing a small-loss series regulator of a two-chip structure of a control IC and a transistor chip.
Fig. 30 is a cross-sectional view showing the small-loss series regulator shown in Fig. 29.

### DESCRIPTION OF THE EMBODIMENTS

### [FIRST EMBODIMENT]

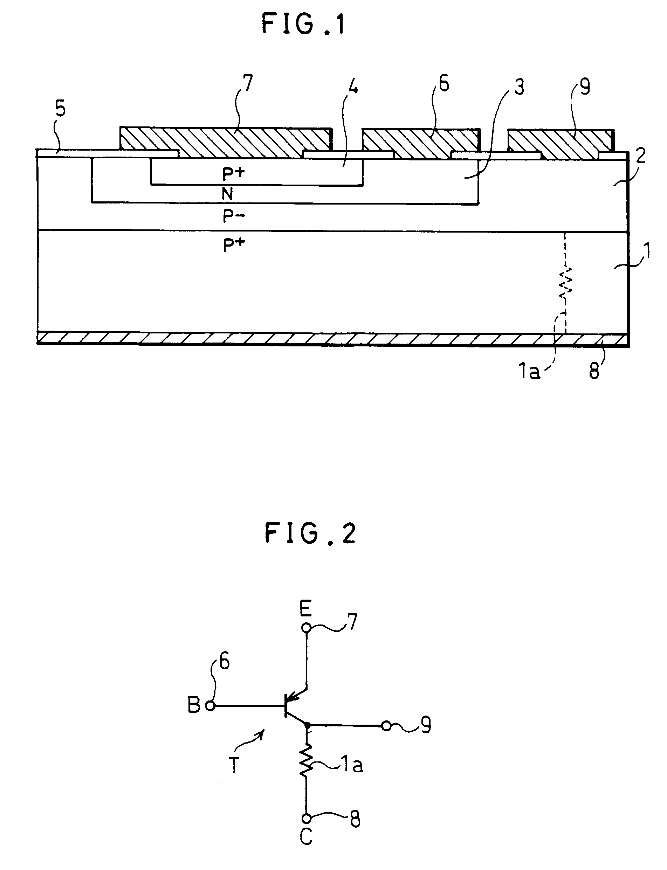

Referring to Figs. 1 through 5, the following description will discuss a first embodiment in accordance with the present invention.

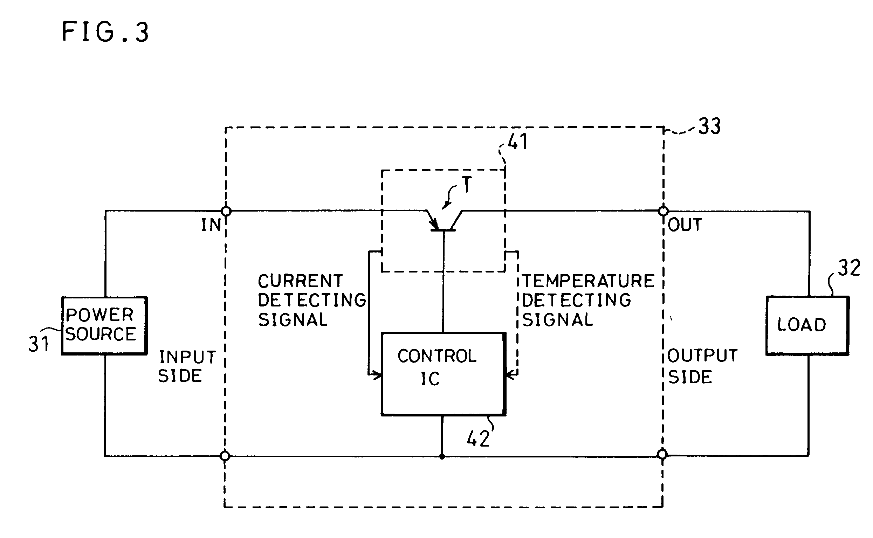

A power transistor in accordance with the present invention is a power transistor causing a small loss, especially, at medium and large current and suitably used for power supply circuits which are likely to induce a surge, such as series regulators and switching regulators. As shown in Fig. 3, a regulator element 33 disposed between a power source 31 and a load 32 includes a transistor chip 41 provided with a power transistor T for controlling the amount of current flowing between the IN terminal and the OUT terminal, and a control integrated circuit (IC) 42 for controlling the base current of the power transistor T. The transistor chip 41 is provided with an electrode from which a signal in accordance with the collector current of the power transistor T is derived as a current detecting signal. The control IC 42 limits the base current of the power transistor T when the current detecting signal indicates am over current. Thus, the power transistor T can be surely prevented from being destroyed by a surge.

The transistor chip 41 and the control IC 42 are sealed in a single package on, for example, a copper frame, and the electrode of the transistor chip 41 is connected to the electrode of the control IC 42 by, for example, wire bonding.

The power transistor in accordance with the present invention is, for example, a planar-type transistor with a base diffusion layer 3 that will act as a base layer selectively formed in a diffused manner on an epitaxial silicon layer 2 and a silicon substrate 1 that will act as a collector layer, and an emitter diffusion layer 4 that will act as an emitter layer selectively formed in a diffused manner on the base diffusion layer 3. The epitaxial silicon layer 2 is specified to be extremely thin, for example less than 1 µm, so as to reduce the saturation voltage between the emitter and the collector. The silicon substrate 1 is specified to be relatively thick, for example about 400 µm.

An insulating film 5 is formed of, for example, an oxide film on the surface of the transistor chip on the side of the epitaxial silicon layer 2. A part of the insulating film 5 is removed where it corresponds to the base diffusion layer 3, and a base electrode 6 is formed where the insulating film 5 is partly removed. Similarly, another part of the insulating film 5 is removed where it corresponds to the emitter diffusion layer 4, and an emitter electrode 7 is formed where the insulating film 5 is partly removed. In contrast, a collector electrode 8 is formed on the surface of the transistor chip on the side of the silicon substrate 1. A vertical (longitudinal) single transistor is formed in this manner. In the following, for convenience of description, the surface of the transistor chip on the side of the epitaxial silicon layer 2 will be referred to as the front surface, and the surface of the transistor chip on the side of the silicon substrate 1 will be referred to as the back surface.

Moreover, in the present embodiment, the base diffusion layer 3 is partly formed smaller, and therefore a part of the front surface of the transistor chip where no base diffusion is carried out is partly formed larger. The corresponding part of the insulating film 5 is removed, and a current detecting electrode 9 from which a voltage drop by resistance of the silicon substrate 1 is derived as a current detecting signal is formed where the insulating film 5 is partly removed. The edge surface of the current detecting electrode 9 closer to the front surface of the transistor chip is formed in a size that allows for wire bonding, for example, in a larger size than a 100 µm × 100 µm square.

The current detecting electrode 9 is formed simultaneously with the power transistor section. More specifically, the insulating film 5 is partly removed to form the current detecting electrode 9 at the same time as parts of the insulating film 5, corresponding to the base diffusion layer 3 and the emitter diffusion layer 4, are removed, and the current detecting electrode 9 is formed at the same time as the base electrode 6 and the emitter electrode 7.

Therefore, the power transistor structured as above can be fabricated by the same process as the normal planar-type transistor. Since the manufacturing process of the planar-type transistor is a well-known conventional technology, detailed description on the manufacturing process of the power transistor is omitted.

The power transistor shown in Fig. 1 is expressed by an equivalent circuit diagram as in Fig. 2. Specifically, since the power transistor is a vertical transistor, the collector of the ideal power transistor T is connected to the collector electrode 8 via a reference resistor la. The connecting point of the collector of the power transistor T to the reference resistor 1a is connected to the current detecting electrode 9. The reference resistor la is primarily constituted by the resistance of the silicon substrate 1, which is indicated by a broken line in Fig. 1.

When the collector current is flowing with the power transistor structured as above, voltage equal to the value of resistance of the silicon substrate 1 multiplied by the collector current is induced across the collector electrode 8 and the current detecting electrode 9. Therefore, the collector current of the power transistor can be detected based on the voltage across the electrodes 8 and 9.

If, in the power transistor having a structure shown in Fig. 1, for example, the transistor chip is of a 1 mm x 1 mm square size (1 mm in length and 1 mm in width), the resistivity of the silicon substrate 1 is 0.01 Ω·cm, the silicon substrate 1 is 400 µm thick, the resistance value of the reference resistor la equals 40 mQ. Therefore, a collector current of 1 A results in a voltage of 40 mV across the collector electrode 8 and the current detecting electrode 9 on the back surface.

Here, for comparison, a brief explanation will be given about a configuration in which a current detecting electrode is disposed at a different position from that of the power transistor of the present embodiment. The power transistor of this comparative example is provided with an emitter current detecting electrode directly connected to the emitter diffusion layer, and is further provided with a resistant layer between the emitter electrode and the emitter diffusion layer. Since the emitter current flows through the resistant layer according to the configuration, the emitter current can be detected by measuring the voltage across both ends of the resistant layer, that is, the voltage across the emitter electrode and the emitter current detecting electrode.

However, such a configuration causes a problem of complex manufacturing process for the power transistor. Specifically, additional steps are needed for forming a resistant layer and for forming an emitter electrode on that resistant layer. Besides, adding a resistor in series to the emitter results in a new problem of a larger loss by the power transistor.

In contrast, in the power transistor of the present embodiment, the resistance of the silicon substrate 1 (reference resistor 1a) is used as a current detecting resistor by providing the current detecting electrode 9 to the epitaxial silicon layer 2 that will act as the collector layer. The reference resistor 1a is a structurally integral factor for a vertical transistor with a collector electrode 8 formed on the back surface of the transistor chip. Therefore, the use of the reference resistor la as a resistor for detecting over current does not increase the resistance of the power transistor. Besides, since the current detecting electrode 9 can be fabricated by the same process as the base electrode 6 and the emitter electrode 7, the power transistor can be manufactured without adding a new step.

With a lateral (latitudinal) transistor of a planar structure, the collector current can be detected by positioning the contact portions of the collector layer so as to sandwich the emitter layer and the base layer, and also by providing a first collector electrode, for deriving current, connected to one of the two contact portions and a second collector electrode, for detecting current, connected to the other contact portion. However, in the above configuration, the resistance of a B/L buried layer provided to the epitaxial layer is mainly used as a detecting resistor for detecting the collector current. Therefore, this configuration cannot be applied to a vertical (longitudinal) transistor.

Now, the following description will explain an application to the power transistor having a channel stopper, as a variation example of the power transistor of the present embodiment. Note that members with the same function as members of the configuration shown in Fig. 1 will be indicated by the same reference numerals and description thereof is omitted.

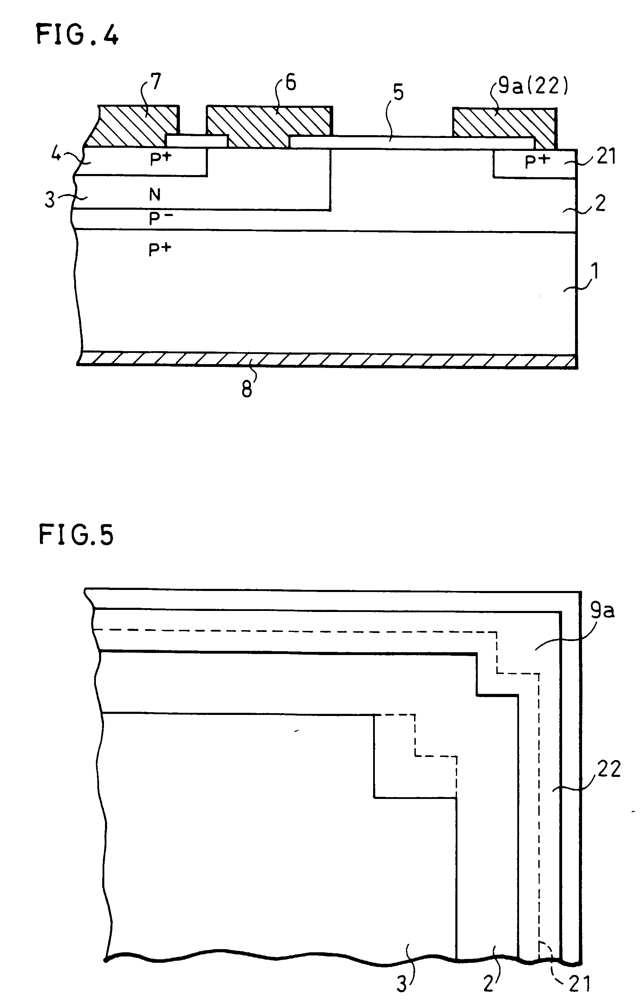

As shown in Fig. 4, a channel stopper 21 of the same conductivity type as the emitter diffusion layer 4 is formed by selective diffusion in a part of the epitaxial silicon layer 2 on the front surface of the transistor chip, that is between the base diffusion layer 3 and an edge of the transistor chip, in order to stop the growth of a depletion layer and obtain stable withstand voltage. For example, in the present example, the distance between the channel stopper 21 and the base diffusion layer 3 is specified to be about 60 µm so as to obtain 50-V withstand voltage. Moreover, the channel stopper 21 is exposed, for example, by removing the part of the insulating film corresponding to the channel stopper 21 after the insulating film 5 is formed also on the channel stopper 21, or by not forming the insulating film 5 on a part corresponding to the channel stopper 21 when forming the insulating film 5 on the epitaxial silicon layer 2. Then a field plate electrode 22 is formed on the exposed channel stopper 21 by the same step as the base electrode 6 and the emitter electrode 7. The field plate electrode 22 is in direct contact with the exposed part of the channel stopper 21. The field plate electrode 22 covers an edge of the insulating film 5 and is extended toward the base diffusion layer 3 on the insulating film 5.

With the configuration, as a reverse voltage is applied to the collector junction, the depletion layer grows toward an edge of the transistor chip from the periphery of the base diffusion layer 3 in the epitaxial silicon layer 2 that will act as the collector layer. As the depletion layer reaches the channel stopper 21, the depletion layer begins to grow from the channel stopper 21 with further increase in the reverse voltage. As a result, the depletion layer stops growing from the base diffusion layer 3, allowing the withstand voltage of the power transistor to be stably maintained at a high level.

Furthermore, since the edge of the insulating film 5 is covered with the field plate electrode 22, the depletion layer can be widened with field plate effect where the depletion layer growing from the base diffusion layer 3 is in contact with the insulating film 5.

A transistor chip including the silicon substrate 1 and the epitaxial silicon layer 2 is, for example, formed in a square shape as shown in the plan view of Fig. 5, and the field plate electrode 22 is provided along the periphery of the transistor chip. To be more specific, along each sideline of the transistor chip, the field plate electrode 22 is in a belt shape of a substantially constant width, and is kept away from the base diffusion layer 3 at a substantially constant distance.

The field plate electrode 22 of the present embodiment is partly formed wider to have an additional function as a current detecting electrode. Specifically, so as to grow toward the base diffusion layer 3, the field plate electrode 22 is wider on at least one corner of the transistor chip than it is along the sidelines. That portion of the field plate electrode 22, which is formed wider, will be referred to as a current detecting electrode 9a in the following. The width of the current detecting electrode 9a is set to not less than 100 µm so as to allow for wire bonding.

The base diffusion layer 3, formed inwardly in the neighborhood of the current detecting electrode 9a, allows a wider field portion near the base diffusion layer 3 than in the other part. Specifically, supposing that the base diffusion layer 3 was formed inwardly opposite to the current detecting electrode 9a as much as the current detecting electrode 9a protrudes as shown by the alternate long and short dash lines in Fig. 5, the field portion between the field plate electrode 22 and the base diffusion layer 3 would have substantially the same width in the neighborhood of the current detecting electrode 9a and in the other part. In such a case, the number of corners, where electric field tends to be concentrated, would be greater in the neighborhood of the current detecting electrode 9a than in the other part, degrading the withstand voltage of the power transistor. In contrast, according to the present embodiment, the base diffusion layer 3 is indented opposite to the current detecting electrode 9a more than the current detecting electrode 9a protrudes as shown by the solid line in Fig. 5. For example, if the sides of the current detecting electrode 9a are 100 µm long, and the field plate electrode 22 is 50 µm wide where the current detecting electrode 9a is not provided, the current detecting electrode 9a protrudes 50 µm inwardly. For this case, the base diffusion layer 3 is formed so as to have an indent greater than 50 µm in the neighborhood of the current detecting electrode 9a. The field portion is thereby wider in the neighborhood of the current detecting electrode 9a than in the other place. As a result, it is possible to prevent the degradation in the withstand voltage of the power transistor, despite the increase in the number of corners, where electric field tends to be concentrated, due to the formation of the current detecting electrode 9a.

In the above configuration, the field plate electrode 22 is partly altered in shape to form the current detecting electrode 9a, which enables the current detecting electrode 9a to be formed without adding a new electrode. Consequently, this configuration can produce the same effects as the configuration shown in Fig. 1, however, with more ease.

### [SECOND EMBODIMENT]

In the first embodiment has been explained a configuration where a collector current detecting electrode is provided to the transistor chip on which the power transistor is formed so as to surely prevent a surge from destructing the power transistor. In contrast, in the present embodiment, a configuration that can assure the prevention of a surge from destructing the power transistor by providing a temperature detecting electrode to the transistor chip on which the power transistor is formed will be explained. In this case, in the regulator element 33 shown in Fig. 3, the control IC 42 limits the base current of the power transistor T based on a temperature detecting signal derived from the electrode of the transistor chip 41. The power transistor T can be surely prevented from being destructed by a surge in this manner.

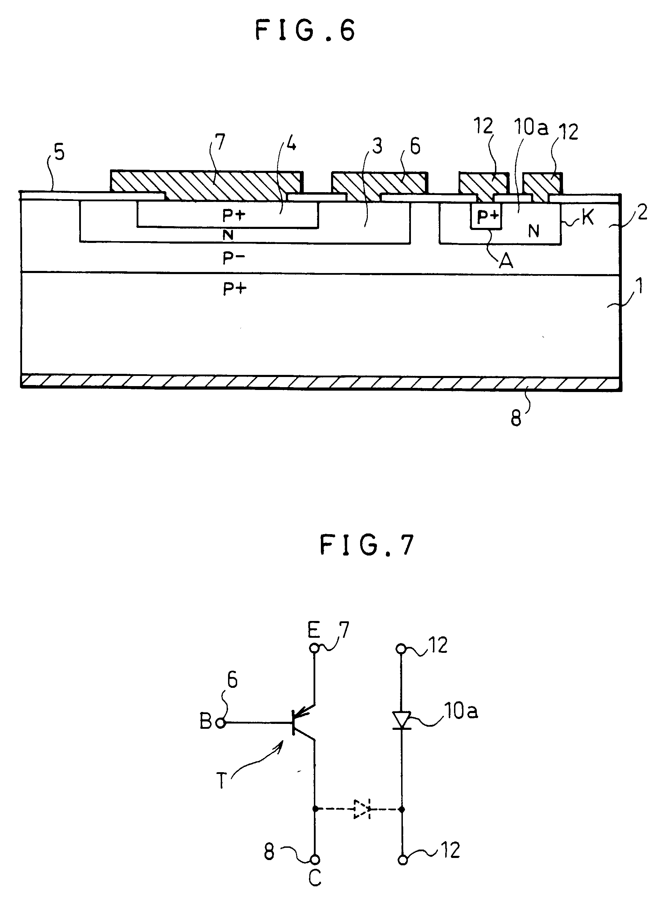

Similarly to the power transistor shown in Fig. 1, the power transistor is, as shown in Fig. 6, an ordinary planar-type transistor with a base layer seiectively formed in a diffused manner on an epitaxial silicon layer 2 and a silicon substrate 1 that will act as a collector layer, and an emitter diffusion layer 4 selectively formed in a diffused manner on the base diffusion layer 3. Parts of an insulating film 5 formed on the front surface of the transistor chip are removed as necessary, and a base electrode 6 and an emitter electrode 7 are formed where the insulating film 5 is partly removed.

In the power transistor of the present embodiment, a junction temperature detecting diode 10a for detecting the junction temperature of the transistor is formed by forming a cathode diffusion layer (N diffusion layer) K and an anode diffusion layer (P⁻ diffusion layer) A on the epitaxial silicon layer- 2 where no base diffusion is carried out with respect to the front surface of the transistor chip. Furthermore, parts of the insulating film 5 on the front surface of the transistor chip are removed where they correspond to the junction temperature detecting diode 10a, and electrodes 12 for deriving a signal from the junction temperature detecting diode 10a are formed where the insulating film 5 is partly removed.

The anode diffusion layer A and the cathode diffusion layer K of the junction temperature detecting diode 10a are formed at the same time as the power transistor section, that is, at the same time as the base diffusion layer 3 and the emitter diffusion layer 4. The insulating film 5 is partly removed, and the electrodes 12 are formed at the same time as the power transistor section is formed, that is, at the same time as a part of the insulating film 5, corresponding to the base diffusion layer 3 and the emitter diffusion layer 4, is removed and as the base electrode 6 and the emitter electrode 7 are formed.

As shown in Fig. 7, the equivalent circuit diagram of the power transistor structured as above includes an ideal power transistor T and a junction temperature detecting diode 10a provided independently from the power transistor T. However, since the junction temperature detecting diode 10a and the power transistor are formed on the same chip, the cathode area K of the junction temperature detecting diode 10a is equivalently connected to the collector of the power transistor T via a diode as shown by a broken line in Fig. 7.

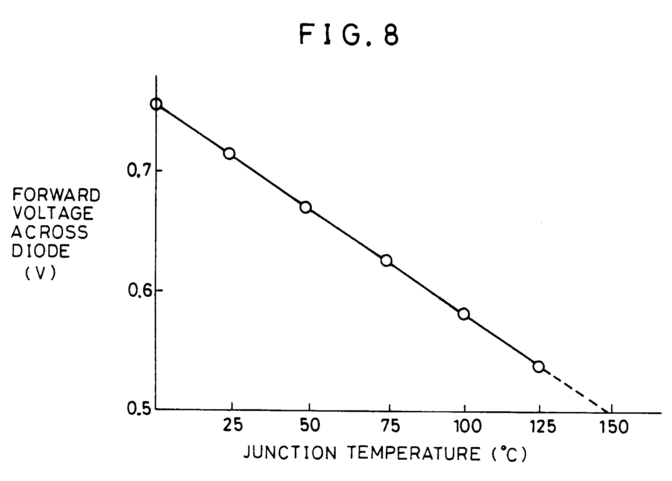

Fig. 8 is a graph showing changes in forward voltage against junction temperature when 1 mA in forward current is passing through the junction temperature detecting diode 10a of the power transistor having the structure shown in Fig. 6. The forward voltage decreases by about 25 % with a rise in junction temperature from 25°C to 125°C.

The junction temperature detecting diode 10a is supplied with predetermined forward current via the electrodes 12 by the control IC 42 shown in Fig. 3. Since the junction temperature detecting diode 10a is provided on the same chip as is the power transistor that is a single transistor, the temperature of the junction temperature detecting diode 10a rises simultaneously as the power transistor generates heat due to current flowing through the power transistor. Therefore, the voltage V across the electrodes 12 that will act as a temperature detecting signal decreases in proportion to the junction temperature of the power transistor as shown in Fig. 8. When the voltage V shows overheating of the power transistor, the control IC 42 limits the heat generation of the power transistor by, for example, limiting the base current applied to the power transistor. The control IC 42 thereby provides protection from overheating to the power transistor.

As described above, since the junction temperature detecting diode 10a is provided on the same chip as is the power transistor, there is little heat resistance between them, and the temperature of the junction temperature detecting diode 10a rises simultaneously as the power transistor generates heat. Therefore, the junction temperature detecting diode 10a can detect the junction temperature of the power transistor quickly and precisely. Besides, the junction temperature detecting diode 10a can be formed by the diffusion to a predetermined part of the epitaxial silicon layer 2 as are the base diffusion layer 3 and the emitter diffusion layer 4, requiring no additional step for preparing the junction temperature detecting diode 10a. As a result, it is possible to offer a power transistor with a temperature detecting electrode without increasing the number of steps in manufacture.

In some cases, depending upon, for instance, the circuit configuration of the control IC, a junction temperature detecting diode should be formed at a different place from that of the junction temperature detecting diode 10a shown in Fig. 6. The following description will explain such modification examples.

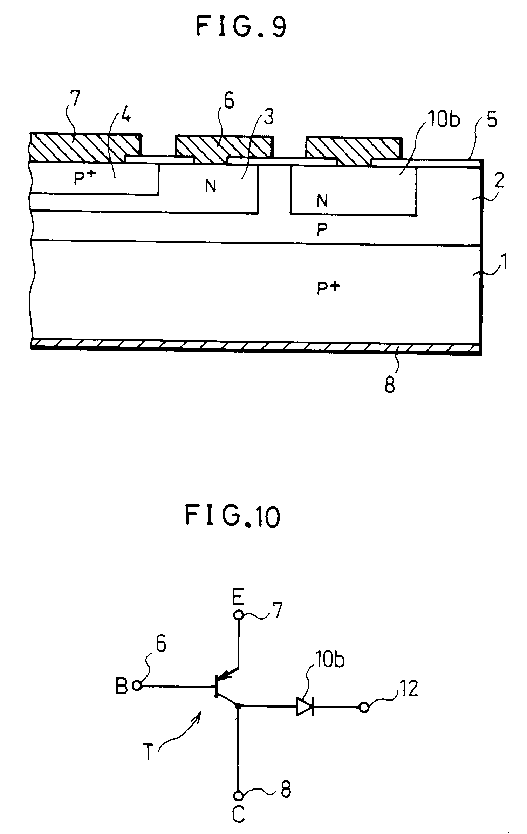

With the power transistor shown in Fig. 9, the cathode area (N diffusion layer) is formed at the base diffusion layer 3. With this configuration, the epitaxial silicon layer 2 acts as an anode area and constitutes a junction temperature detecting diode 10b. The collector electrode 8 is also used as the electrode 12 connected to the anode area. In the equivalent circuit diagram shown in Fig. 10, the junction temperature detecting diode 10b is connected to the collector of the equivalent power transistor T. As can be understood from Fig. 10, the power transistor of the present modification example is provided with a diode equivalently disposed at a different place, and the collector electrode of the transistor that can also be used as an electrode for the diode. Therefore, it is possible to reduce the chip area and the number of wires connected to the frame.

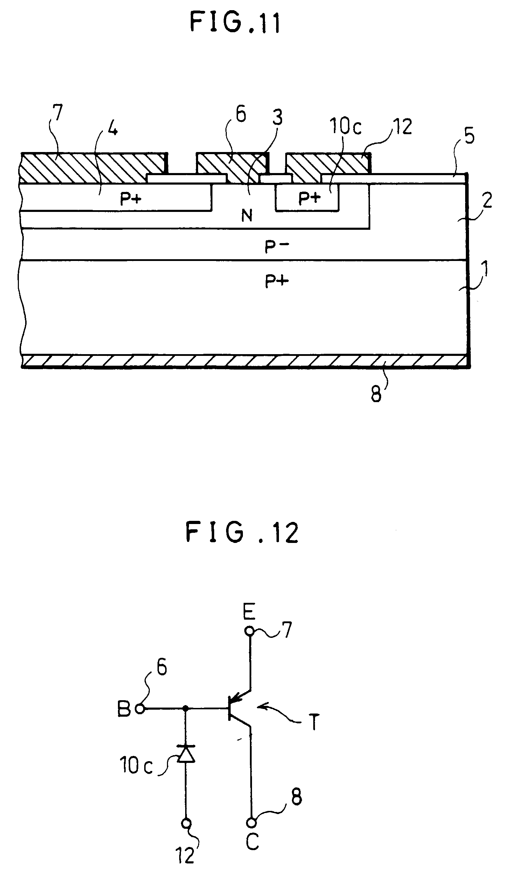

With the power transistor shown in Fig. 11, as another modification example, a junction temperature detecting diode 10c is formed by providing an anode area A to the base diffusion layer 3. With the junction temperature detecting diode 10c, the base diffusion layer 3 is also used as the cathode area K, and the base electrode 6 is also used as the electrode 12 connected to the cathode area K. Therefore, in the equivalent circuit diagram shown in Fig. 12, the junction temperature detecting diode 10c is connected to the base of the equivalent power transistor T. As can be understood from Fig. 12 in comparison to the configuration shown in Fig. 6, the power transistor of the present modification example is provided with a diode equivalently disposed at a different place, and the base electrode of the transistor that can also be used as an electrode for the diode. Therefore, it is possible to reduce the chip area and the number of wires connected to the frame.

For comparison, the following will briefly explain a configuration in which a current detecting electrode is provided at a different place from that of the power transistor of the present embodiment. With the power transistor of this comparative example, a polysilicon film is formed on an insulating film on the transistor section, and a diode is formed on that polysilicon film. However, in this configuration, new steps of ion injection and heat treatment should be added to the steps for forming the power transistor in order to form the Ptype area and the N-type area for the diode, complicating the manufacturing process of the power transistor.

In contrast, with the power transistor of the present embodiment, the cathode area K and the anode area A constituting the junction temperature detecting diodes 10a through 10c are provided to the epitaxial silicon layer 2 of the power transistor by selective diffusion. As a result, the areas K and A can be formed by the same steps as the base diffusion layer 3 and the emitter diffusion layer 4 of the power transistor. As a result, it is possible to manufacture a power transistor that can detect the junction temperature without complicating the manufacturing process.

Note that with the power transistor shown in Fig. 9, the collector electrode 8 is also used as the electrode 12, and the forward current supplied to the junction temperature detecting diode 10b flows via the silicon substrate 1. As a result, a loss is caused by the resistance of the silicon substrate 1 and increases the amount of heat generated by the power transistor. Moreover, the resistance value of the silicon substrate 1 varies and affected by temperature. So the voltage between the electrode 12 on the front surface of the transistor chip and the collector electrode 8 on the back surface thereof is affected by the variation and temperature characteristics of the resistance of the silicon substrate 1, and thereby possibly degrades precision in detecting the junction temperature.

Meanwhile, with the power transistors shown in Figs. 6 and 11, the current flowing through the junction temperature detecting diode 10a (10c) does not travel through the silicon substrate 1, but mainly flows parallel to the front surface of the transistor chip.

Therefore, these power transistors can better restrain loss and heat generation and thereby more precisely detect the junction temperature than the power transistor shown in Fig. 9. In addition, the voltage across the electrodes 12 is not affected by the variation or temperature characteristics of the resistance of the silicon substrate 1. Therefore, it is possible to further improve the precision in detecting the junction temperature.

Furthermore, the voltage across the electrodes 12 is less likely to be affected by parasitic effect of the power transistor when the electrodes 12 are provided independently from the electrodes (6, 8, etc.) of the power transistor as shown in Fig. 6, than when an electrode of the power transistor is also used as an electrode 12. Therefore, the control IC 42 shown in Fig. 3 is less likely to be affected (e.g., noise) by high current or high voltage applied to the power transistor, further enhancing the precision in detecting the junction temperature.

The junction temperature detecting diodes 10a through 10c can detect the junction temperature of the power transistors more quickly and more precisely when provided on the same chip as are the power transistors, than when not provided on the same chip. Therefore, even if provided on, for example, an edge of the transistor chips, the desired effects can be obtained.

However, in order to detect the junction temperature of the power transistors more quickly and precisely, the junction temperature detecting diodes 10a through 10c should be disposed in the following manner. In a power transistor, the central part of the transistor chip has the heaviest concentration of current, and thus the heaviest concentration of generated heat. Therefore, in order to surely prevent increase in temperature from destructing the power transistors, the junction temperature detecting diode 10a (10b and 10c) should be disposed in the central part of the transistor chip.

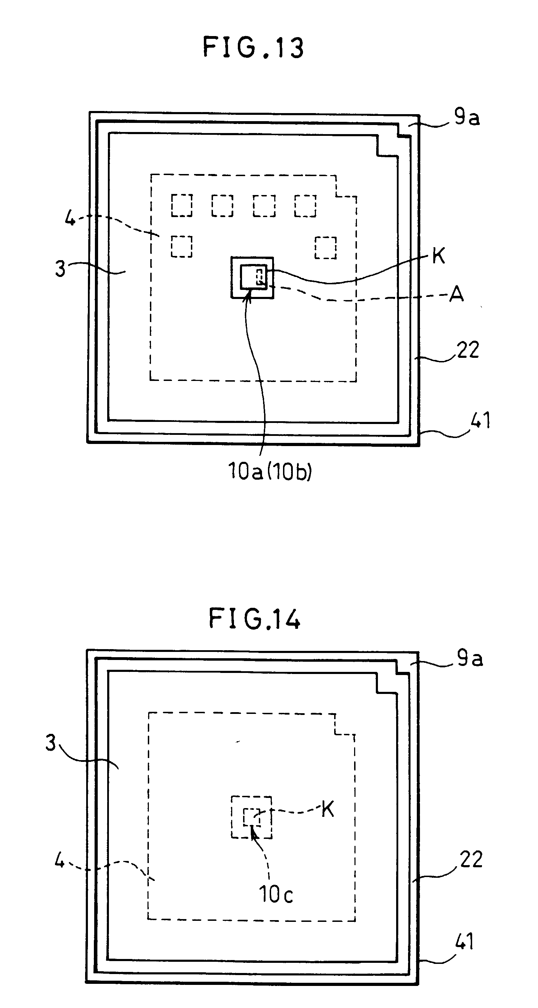

For example, as for the power transistors shown in Figs. 6 and 9, the cathode area K of the junction temperature detecting diode 10a (10b) is formed in the central part of the front surface of the transistor chip as shown in Fig. 13. The base diffusion layer 3 is formed to have an empty space therein in a manner to surround the cathode area K. The cathode area K and the base diffusion layer 3 are formed by the same step. In addition, as for the power transistor shown in Fig. 6, the anode diffusion layer (P⁺) A is formed in the cathode area K by the same step for selectively diffusing the emitter diffusion layer (P⁺ diffusion layer) 4. Note that Fig. 13 shows as an example the emitter diffusion layer 4 formed in a mesh form.

As for the power transistor shown in Fig. 11, the anode area A of the junction temperature detecting diode 10c and the emitter diffusion layer 4 formed to have an empty space therein in a manner to surround the anode area A are formed by selective diffusion on the base diffusion layer 3 as shown in Fig. 14.

As shown in Figs. 13 and 14, the junction temperature detecting diodes 10a through 10c, formed in the central part of the front surface of the transistor chip, are disposed where the power transistors have the highest temperature. Therefore, the junction temperature detecting diodes 10a through 10c thus provided can more quickly and precisely detect the junction temperature of the power transistors, and can more reliably prevent the power transistors from being destructed by a surge, than the junction temperature detecting diodes 10a through 10c provided elsewhere.

Figs. 13 and 14 show a current detecting electrode formed on one of corners of a transistor chip in the same manner as in the first embodiment. Therefore, the base diffusion layer 3 and the emitter diffusion layer 4 are formed in an inwardly indented manner at the corner thereof facing the current detecting electrode.

### [THIRD EMBODIMENT]

In the second embodiment has been explained a configuration where a diode is used to detect the junction temperature of the power transistor. In contrast, in the present embodiment will be explained a configuration where the junction temperature is detected with a resistor provided to the power transistor.

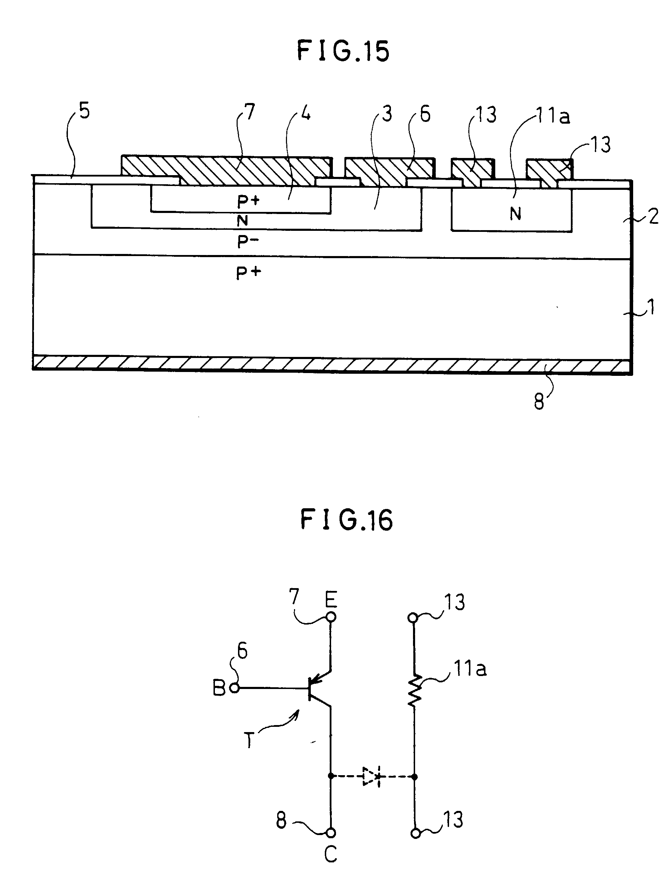

As shown in the cross-sectional view in Fig. 15, similarly to the power transistor of the second embodiment, the power transistor of the present embodiment is an ordinary planar-type transistor with a base layer selectively formed in a diffused manner on an epitaxial silicon layer 2 and a silicon substrate 1 that will act as a collector layer, and an emitter diffusion layer 4 selectively formed in a diffused manner on the base diffusion layer 3. Parts of an insulating film 5 formed on the front surface of the transistor chip are removed as necessary, and a base electrode 6 and an emitter electrode 7 are formed where the insulating film 5 is partly removed.

In the power transistor of the present embodiment, a junction temperature detecting resistor 11a for detecting the junction temperature of the transistor is formed by forming a impurity diffusion layer (N diffusion layer) on the epitaxial silicon layer 2 where no base diffusion is carried out with respect to the front surface of the transistor chip. Furthermore, parts of the insulating film 5 on the front surface of the transistor chip are removed where they correspond to the junction temperature detecting resistor 11a, and electrodes 13 for deriving a signal from the junction temperature detecting resistor 11a are formed where the insulating film 5 is partly removed.

The impurity diffusion layer of the junction temperature detecting resistor 11a is formed at the same time as the power transistor section, that is, at the same time as the base diffusion layer 3. The insulating film 5 is partly removed, and the electrodes 13 are formed at the same time as the power transistor section is formed, that is, at the same time as parts of the insulating film 5, corresponding to the base diffusion layer 3 and the emitter diffusion layer 4, are removed and as the base electrode 6 and the emitter electrode 7 are formed.

As shown in Fig. 16, the equivalent circuit diagram of the power transistor structured as above includes an ideal power transistor T and a junction temperature detecting resistor 11a provided independently from each other. However, since the junction temperature detecting resistor lla and the power transistor T are formed on the same chip, the PN junction is formed by the epitaxial silicon layer 2 that will act as a collector layer and the N diffusion layer of the junction temperature detecting resistor 11a. Therefore, the junction temperature detecting resistor 11a is equivalently connected to the collector of the power transistor T as shown by a broken line in Fig. 16.

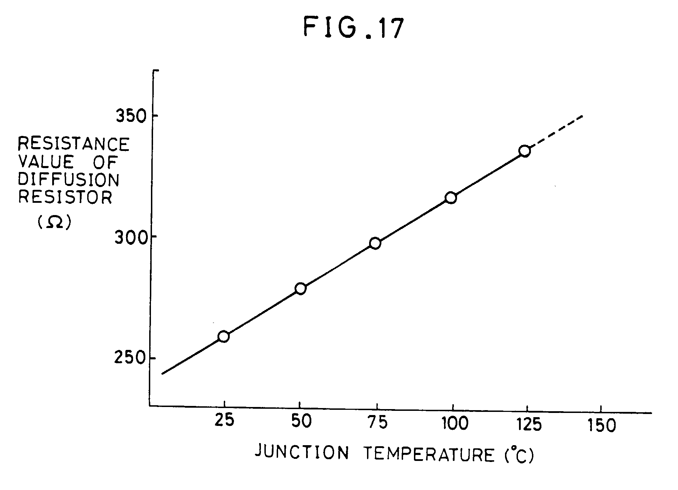

Fig. 17 is a graph showing changes in resistance against junction temperature when the junction temperature detecting resistor 11a is 10 µm wide and 400 µm long. The resistance value increases by about 30 % with a rise in junction temperature from 25°C to 125°C.

The junction temperature detecting resistor 11a is supplied with predetermined current via the electrodes 13 by the control IC 42 shown in Fig. 3. Since the junction temperature detecting resistor 11a is provided on the same chip as is the power transistor that is a single transistor, the temperature of the junction temperature detecting resistor 11a rises simultaneously as the power transistor generates heat due to current flowing through the power transistor. Therefore, the voltage V across the electrodes 13 increases in proportion to the junction temperature of the power transistor as shown in Fig. 17. The voltage V is fed back to the control IC 42 as a temperature detecting signal in the same manner as in the second embodiment, and the control IC 42 provides protection from heat to the power transistor according to the temperature detecting signal.

As described above, since the junction temperature detecting resistor 11a is provided on the same chip as is the power transistor, there is little heat resistance between them, and the temperature of the junction temperature detecting resistor 11a rises simultaneously as the power transistor generates heat. Therefore, the junction temperature detecting resistor 11a can detect the junction temperature of the power transistor quickly and precisely. Besides, the junction temperature detecting resistor 11a can be formed by the diffusion to a predetermined part of the epitaxial silicon layer 2 as are the base diffusion layer 3 and the emitter diffusion layer 4, requiring no additional step for preparing the junction temperature detecting resistor 11a. As a result, it is possible to offer a power transistor with a temperature detecting electrode without increasing the number of steps in manufacture.

In some cases, depending upon, for instance, the circuit configuration of the control IC, a junction temperature detecting resistor should be formed at a different place from that of the junction temperature detecting resistor 11a shown in Fig. 15. The following description will explain such modification examples.

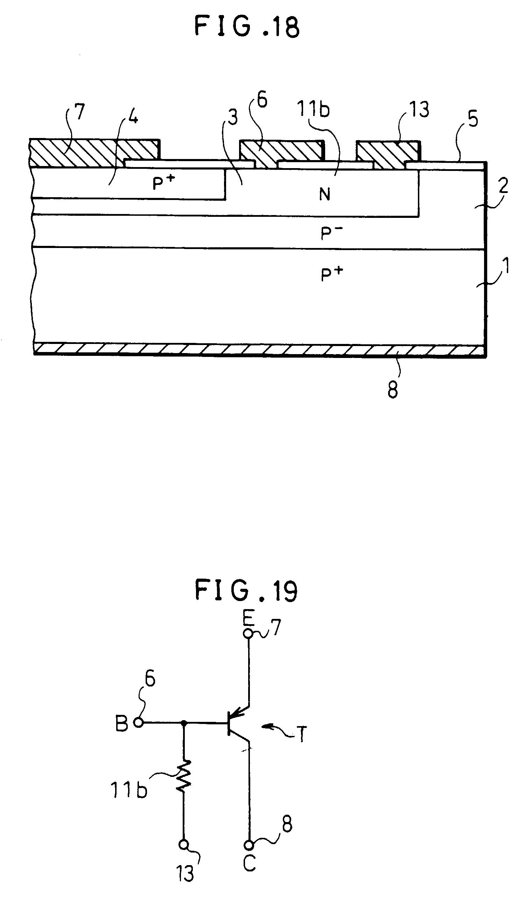

For example, with the power transistor shown in Fig. 18, the electrode 13 for detecting the junction temperature is formed so as to be electrically connected to the base diffusion layer 3 at a different place from the base electrode 6. With this configuration, a part of the base diffusion layer 3 is used as a junction temperature detecting resistor 11b. The electrode 13 can be formed by the same step as the base electrode 6.

With the configuration, the base diffusion layer 3 is also used as the impurity diffusion layer constituting the junction temperature detecting resistor 11b, and the base electrode 6 is also used as one of the junction temperature detecting electrodes 13. Therefore, in the present embodiment, as shown in the equivalent circuit diagram in Fig. 19, the junction temperature detecting resistor 11b is connected to the base of the equivalent power transistor T.

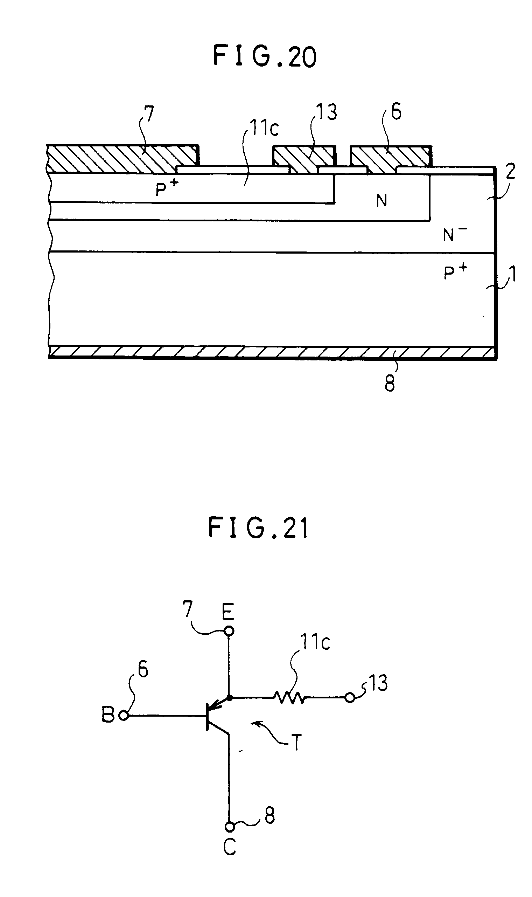

Fig. 20 shows another modification example of a power transistor in which the electrode 13 for detecting the junction temperature is formed so as to be electrically connected to the emitter diffusion layer 4 at a different place from the emitter electrode 7. With this configuration, a part of the emitter diffusion layer 4 is used as a junction temperature detecting resistor 11c. The electrode 13 can be formed by the same step as the emitter electrode 7.

With the configuration, the emitter diffusion layer 4 is also used as the impurity diffusion layer constituting the junction temperature detecting resistor 11c, and the emitter electrode 7 is also used as one of the electrodes 13 for detecting the junction temperature. Therefore, in the present modification example, as shown in the equivalent circuit diagram in Fig. 21, the junction temperature detecting resistor 11c is connected to the emitter of the equivalent power transistor T.

Note that with the configurations shown in Figs. 18 and 20, the impurity diffusion layer constituting the power transistor is also used as the impurity diffusion layer constituting the junction temperature detecting resistor 11b (11c), and the electrode of the power transistor is also used as one of the electrodes 13. Therefore, it is possible to reduce the chip area and the number of wires connected to the frame.

Figs. 15, 18 and 20 show power transistors in which the junction temperature detecting resistors 11a, 11b, and 11c are formed from a single impurity diffusion layer. In this case, the junction temperature detecting resistor has a resistance of several hundred Ω if the impurity diffusion layer is an N diffusion layer as shown in Figs. 15 and 18, and has a resistance of several Ω if the impurity diffusion layer is a P⁺ diffusion layer as shown in Fig. 20.

However, the junction temperature detecting resistor in accordance with the present invention, not limited to take the structures as above, can take various structures depending upon the necessary resistance values.

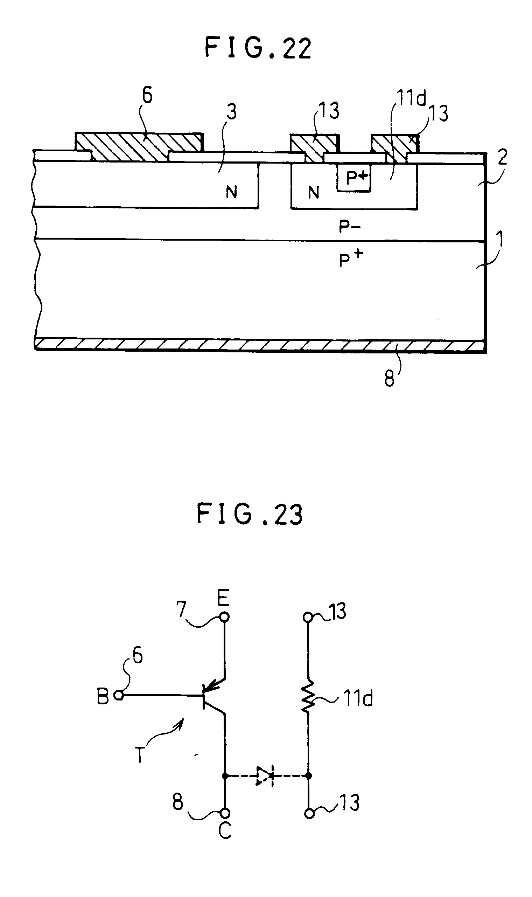

For example, with the power transistor shown in Fig. 22, a junction temperature detecting resistor 11d of a pinch resistance structure is used. Specifically, an N diffusion layer is formed for the junction temperature detecting resistor 11d separately from the base diffusion layer 3, and a P⁺ diffusion layer is provided to the N diffusion layer. The P⁺ diffusion layer can be formed by the same step as the emitter diffusion layer 4. Furthermore, the electrodes 13 are formed to sandwich the P⁺ diffusion layer in the N diffusion layer. The junction temperature detecting resistor 11d of a pinch resistance structure giving the largest resistance value is thus formed. In this case, the power transistor is expressed by an equivalent circuit diagram as in Fig. 23, which is similar to the circuit diagram in Fig. 16, with the junction temperature detecting resistor 11d having a resistance value of about several kΩ.

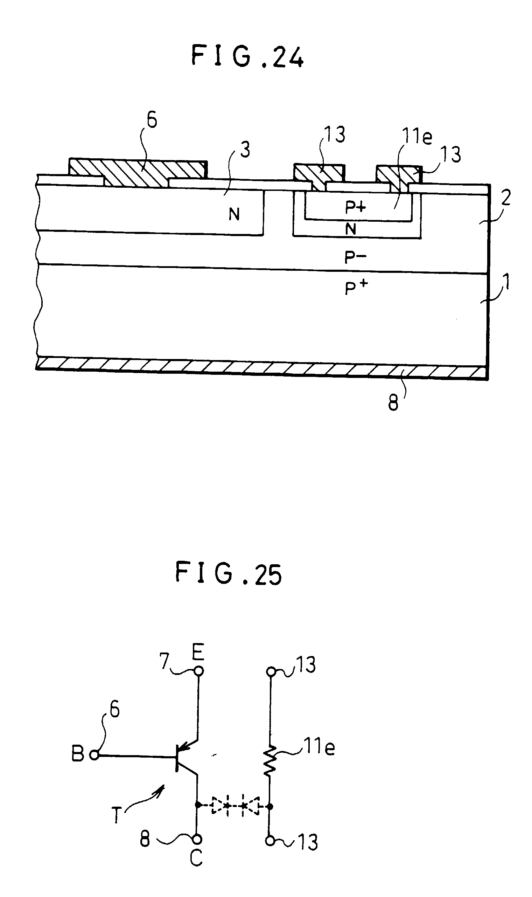

In addition, with the power transistor shown in Fig. 24, a junction temperature detecting resistor 11e of a structure using high-density emitter diffusion resistor is used. Specifically, an N diffusion layer is formed for the junction temperature detecting resistor 11d separately from the base diffusion layer 3, and a P⁺ diffusion layer is provided to the N diffusion layer. Furthermore, the electrodes 13, separated by a predetermined distance from each other, are connected to the P⁺ diffusion layer. The junction temperature detecting resistor 11e is thus formed by high-density emitter diffusion resistor of the lowest resistance value is formed. In this case, the junction temperature detecting resistor 11e has a resistance of about several Ω. Besides, since with this configuration a PN junction is formed between the P⁺ diffusion layer of the junction temperature detecting resistor 11e and the N diffusion layer, and between the N diffusion layer and the epitaxial silicon layer 2, diodes connected in series to each other's cathode equivalently exist between the collector of the equivalent power transistor T and the junction temperature detecting resistor lle in the equivalent circuit diagram in Fig. 25.

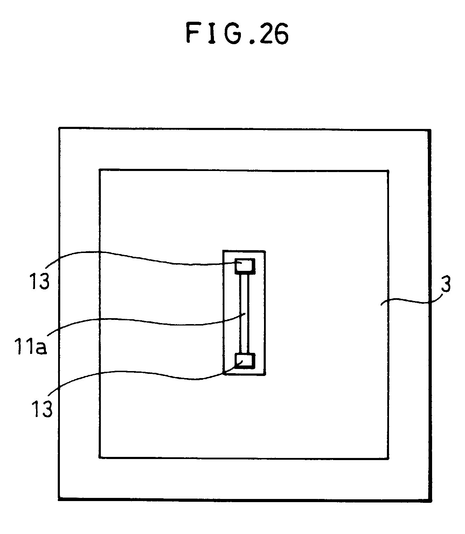

Here, similarly to the junction temperature detecting diodes 10a through 10c of the second embodiment, the junction temperature detecting resistors 11a through 11e should preferably be formed in the central part of the transistor chip. Taking the junction temperature detecting resistor lla in Fig. 17 as an example, an N diffusion layer is formed for the junction temperature detecting resistor 11a in the central part of the epitaxial silicon layer 2 as shown in Fig. 26, and the empty base diffusion layer 3 is formed so as to surround the N diffusion layer.

The junction temperature detecting resistors 11a through 11e, formed in the central part of the transistor chip where a greatest amount of heat is generated, can more quickly and precisely detect the junction temperature of the power transistors, and more reliably prevent the power transistors from being destructed by a surge, than the junction temperature detecting resistors 11a through 11e provided elsewhere.

The temperature detecting signal can be transmitted to the control IC 42 shown in Fig. 3 if either one of the junction temperature detecting diode of the second embodiment and the junction temperature detecting resistor of the present embodiment is provided. However, the temperature detecting signal of the present embodiment shows a positive correlation with the temperature, whereas the temperature detecting signal of the second embodiment shows a negative correlation with the temperature. Therefore, one of the transistor structures of the two embodiments is chosen depending upon the circuit structure of the control IC 42. Note that since the first embodiment differs from the second and third embodiments in the use and position of the electrode, the first embodiment can be used in combination with the second or third embodiment.

Although the present invention has been so far described with respect to planar-type power transistors in the first to third embodiments, there are alternatives. The invention can be applied to mesa-type power transistors and still produce the same effects, unless the N diffusion layer constituting the junction temperature detecting diode or the diode section is separated from the base diffusion layer 3 of the power transistor. Moreover, although the invention has been applied to PNP power transistors as examples in the embodiments so far, it can be applied to NPN power transistors as well by changing the conductivity types.

As described so far, the first power transistor in accordance with the present invention is a planar-type transistor in which a base layer is selectively diffused on a silicon substrate that will act as a collector layer, and an emitter layer is selectively diffused thereon, and is characterized in that an electrode for deriving a voltage drop caused by a resistance of the silicon substrate as a current detecting signal is provided to the collector layer on the front surface of the transistor chip.

With the configuration, voltage that equals the amount of the current multiplied by the resistance value of the silicon substrate is generated between the collector electrode on the back surface and the current detecting electrode on the front surface, which enables the detection of the collector current of the power transistor.

The second power transistor in accordance with the present invention is a planar-type transistor in which a base layer is selectively diffused on a silicon substrate that will act as a collector layer, and an emitter layer is selectively diffused thereon, and is characterized in that a diode section for detecting the junction temperature of the transistor and an electrode for deriving a signal from the diode section are provided to the collector layer on the front surface of the transistor chip.

With the configuration, since the diode section is provided on the same chip as the power transistor, the diode section has a temperature that is equal to the junction temperature of the power transistor. Therefore, the junction temperature of the power transistor can be detected by measuring the forward voltage of the diode that varies in proportion to the temperature.

The third power transistor in accordance with the present invention is a planar-type transistor in which a base layer is selectively diffused on a silicon substrate that will act as a collector layer, and an emitter layer is selectively diffused thereon, and is characterized in that a resistor section for detecting the junction temperature of the transistor and an electrode for deriving a signal from the resistor section are provided to the collector layer on the front surface of the transistor chip.

With the configuration, since the resistor section is provided on the same chip as the power transistor, the resistor section has a temperature that is equal to the junction temperature of the power transistor. Therefore, the junction temperature of the power transistor can be detected by measuring the resistance value of the resistor section that varies in proportion to the temperature.

With the configurations of the first to third power transistors, it becomes possible to quickly and precisely detect the collector current or the junction temperature of a transistor chip by adding a bonding pad or providing a diode or resistor section of a small area to a part of the transistor chip by exactly the same process as ordinary power transistors are manufactured. Moreover, it becomes unnecessary to provide a conventionally integral external resistor for detecting over current, and it becomes possible to attempt to reduce in size, and simplify, the circuit.

Moreover, in a regulator element constituted by a power transistor and a control IC chip, for example, it becomes possible to quickly and precisely detect sudden heat generation by the power transistor, which has been difficult to detect with conventional methods, and to surely prevent destruction by a surge by controlling the base current with the detection signal transmitted to the control IC.

Furthermore, a conventional power transistor, having no protection function in accordance with the present invention, needs to have a surge withstanding capability not to be destructed by anticipated surge current. By contrast, a normal surge withstanding capability in normal use conditions, if used together with a protection function in accordance with the present invention, well serves the needs and allows for great reduction in the chip size of the power transistor.

The invention being thus described, it will be obvious that the same may be varied in many ways. Such variations are not to be regarded as a departure from the spirit and scope of the invention, and all such modifications as would be obvious to one skilled in the art intended to be included within the scope of the following claims.

For example, though the examples given above relate to a silicon substrate. the invention is not limited to this. Any conventional substrate, for example a GaAs substrate. could be used.

## Claims

1. A power transistor, comprising:
a transistor chip including
a substrate acting in use, as a collector layer,
a base layer formed on said substrate by selective diffusion, and
an emitter layer fore on said base layer by selective diffusion; and
a current detecting electrode, provided on said collector layer on a surface of said transistor chip, the surface being on the same side of the chip as said base layer, for deriving a voltage drop caused by the resistance of said substrate as a current detecting signal.

2. The power transistor as defined in claim 1, further comprising:
a collector electrode provided on a surface of said transistor chip that is opposite to the side of said base layer.

3. The power transistor as defined in claim 1, further comprising:
a channel stopper, formed outside said base layer on said substrate by selective diffusion, for stopping growth of a depletion layer from said base layer;
an insulating film formed between said base layer and said channel stopper on said substrate; and
a field plate electrode electrically connected to said channel stopper and formed so as to cover an edge of said insulating film near said channel stopper,
wherein said current detecting electrode is a part of said field plate electrode.

4. The power transistor as defined in claim 3,
wherein said current detecting electrode has a size specified to allow for wire bonding.

5. The power transistor as defined in claim 4,
wherein said current detecting electrode is formed in a larger size than a 100 µm x 100 µm square.

6. The power transistor as defined in claim 3,
wherein said current detecting electrode is formed by extending said field plate electrode toward said base layer, and
said base layer is formed to be indented inwardly in the neighborhood of said current detecting electrode by a larger amount than said field plate electrode is extended.

7. A power transistor, comprising :
a transistor chip including
a substrate acting, in use, as a collector layer,
a base layer formed on said substrate by selective diffusion, and
an emitter layer formed on said base layer by selective diffusion;
a detecting section, provided to said collector layer on a surface of said transistor chip, the surface being on the same side of the chips as said base layer for detecting temperature;
a first electrode provided to said transistor chip on the side of said base Layer and electrically connected to said detecting section; and
a second electrode provided to said transistor chip on the side of said base layer and electrically connected to said detecting section,
said first and second electrodes being connected to said detecting section at different places.

8. The power transistor as defined in claim 7,
wherein said detecting section is a resistor formed by selective diffusion and having resistance variable with change in temperature.

9. The power transistor as defined in claim 8,
wherein said detecting section is at least part of said base layer, and
said first electrode is a base electrode electrically connected to said base layer.

10. The power transistor as defined in claim 8,
wherein said detecting section is at least part of said emitter layer, and
said first electrode is an emitter electrode electrically connected to said emitter layer.

11. The power transistor as defined in claim 8,
wherein said detecting section is formed separately from said base layer and said emitter layer.

12. The power transistor as defined in claim 8,
wherein said detecting section has a pinch resistance structure.

13. The power transistor as defined in claim 8,
wherein said detecting section is an emitter diffusion resistor.

14. The power transistor as defined in claim 7,
wherein said detecting section is a diode provided with a first area connected to said first electrode and a second area connected to said second electrode, said second area having a different conductivity type from said first area, said diode being variable in forward voltage with change in temperature.

15. The power transistor as defined in claim 14,
wherein said first area is at least part of said base layer, and
said first electrode is a base electrode electrically connected to said base layer.

16. The power transistor as defined in claim 14,
wherein said first area is formed separately from said base layer.

17. The power transistor as defined in claim 7,
wherein said detecting section is formed at the center of said surface of said transistor chip.
